# EUROPEAN PATENT APPLICATION

(11) **EP 1 739 487 A1**
(43) Date of publication of application: **03.01.2007**
(21) Application number: 05710408.5
(22) Date of filing: 18.02.2005
(51) Int. Cl.: G03F 7/11, H05K 3/34

(54) **BILAYER LAMINATED FILM FOR BUMP FORMATION AND METHOD OF BUMP FORMATION**

(30) Priority: 20.02.2004 JP 2004044929
(71) Applicant: JSR Corporation, Tokyo 104-0045 (JP)
(72) Inventor: SAKAI, Hiroko c/o JSR CORPORATION, Tokyo 1040045 (JP); OHTA, Masaru, c/o JSR CORPORATION, Tokyo 1040045 (JP); INOMATA, Katsumi, c/o JSR CORPORATION, Tokyo 1040045 (JP); IWANAGA, Shin-ichiro, c/o JSR CORPORATION, Tokyo 1040045 (JP)
(74) Representative: TBK-Patent
(86) International application number: PCT/JP2005/002575
(87) International publication number: WO 2005/081064

(57) **Abstract**

A negative radiation-sensitive two-layer laminated film for forming bumps includes a lower layer that includes a composition including a polymer (A) with a specific structural unit and an organic solvent (B). A process for forming bumps uses the laminated film.

The negative radiation-sensitive two-layer laminated film for forming bumps permits excellent printing of a solder paste, is patternable with good configuration, and is easily peeled from a substrate. The bump-forming process using the laminated film provides the same effects.

## Description

### FIELD OF THE INVENTION

The present invention relates to a process for forming low-melting metal bumps such as solder bumps used in the mounting of IC chips on a multilayer printed wiring board. The invention is also concerned with a two-layer laminated film suited for use in the process.

### BACKGROUND OF THE INVENTION

Low-melting metal bumps such as solder bumps are used for the mounting of IC chips and other parts. Formation of such bumps takes place on the IC chips or on the multilayer printed wiring board.

BGA (ball grid array) is a form of package in which the bumps are provided on IC chips. This term generally refers to a package in which the IC chips are mounted on a package substrate.

WL-CSP (wafer level-chip size packaging) is a new technology for the high-density mounting. In the WL-CSP, a plurality of IC chip circuits is formed on one wafer and collectively subjected to electrode formation, packaging and burn-in test; thereafter the wafer is cut into IC chip packages.

Collective electrode formation in the WL-CSP may be performed by electroplating, applying a metal paste followed by reflowing, or placing metal balls followed by reflowing.

The increase of IC chip density has led to higher density and miniaturization of bumps on the IC chips. Solder bumps have increasingly been studied and been in practical use in the WL-CSP mounting technology because they allow both connection reliability and reduced processing cost. Specifically, the solder bumps are formed by electrolytic deposition through a mask. The mask used herein is produced by patterning a film at least 50 µm in thickness provided by application or lamination of a positive or negative vanish radiation-sensitive resin composition or dry film.

Meanwhile, when the solder bumps are formed on a multilayer printed wiring board, a solder resist layer is provided on the wiring board to prevent fusion bonding of the solder bumps. The solder resist layer has apertures at positions corresponding to electrode pads. To form the solder bumps in the solder resist layer, a solder paste is printed through a mask. The mask printing uses a metal mask having a pattern (pattern of apertures) that corresponds to the apertures of the solder resist layer. In carrying out the mask printing, the metal mask is placed so as to align the mask pattern and the apertures of the solder resist layer. The solder paste is printed through the metal mask within the apertures of the solder resist layer on the electrode pads; subsequently, the solder paste is reflowed to form solder bumps on the electrode pads.

A variety of studies have been made to cope with the reduction of solder bump pitches. For example, Patent Document 1 discloses that a peelable solder dam resist is formed on a solder resist. Patent Document 2 discloses a method in which a dry film is laminated on the solder resist, apertures are created at positions corresponding to electrode pads, a solder paste is applied followed by reflowing, and the dry film is peeled.

In the aforementioned processes of bump formation, the positive resist, although easily peelable in general, causes difficult control of the aperture pattern configuration, often resulting in nonuniform bump sizes.

The negative resist permits relatively easy control of pattern shape, but is generally difficult to peel because of its photocrosslinking characteristics. In particular, when the solder bumps are formed by applying and reflowing the paste, the resist becomes even more difficult to peel from the substrate because the negative radiation-sensitive resin composition is crosslinked to a further extent by the heat applied in the reflowing.

The resist films are generally peeled by spraying an aqueous solution of sodium hydroxide or sodium carbonate, which is inexpensive. This spraying method, however, often results in residual resists around the bumps having a high density, and consequently the bumps are deteriorated.

In the case of the dry-film or varnish negative radiation-sensitive resin composition, an increasingly frequent method of peeling is a dip method that uses a peeling solution containing a highly polar solvent and an organic alkali. However, the dip method has disadvantages that the peeling solution is expensive, and the surfaces of the metal bumps and the underlying substrate are corroded when the organic alkali concentration and the peeling solution temperature are increased for improving the peeling efficiency per amount of the peeling solution.
Patent Document 1: JP-A-H10-350230
Patent Document 2: JP-A-2000-208911

### DISCLOSURE OF THE INVENTION

### PROBLEMS TO BE SOLVED BY THE INVENTION

It is an object of the present invention to provide a bump-forming negative radiation-sensitive two-layer laminated film that permits excellent printing of a solder paste, is patternable with good configuration, and is easily peeled from a substrate. It is another object of the invention to provide a process for forming bumps using the laminated film.

### MEANS FOR SOLVING THE PROBLEMS

A two-layer laminated film according to the present invention comprises:
(I) a lower layer comprising a composition including a polymer (A) and an organic solvent (B); and
(II) an upper layer comprising a negative radiation-sensitive resin composition;
   the polymer (A) including a structural unit represented by Formula (1) :

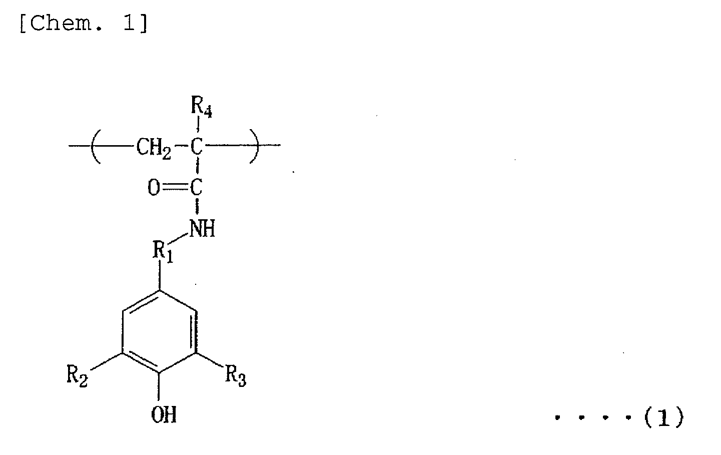

wherein R₁ is -(CH₂)ₙ- where n is an integer of 0 to 3, and R₂, R₃ and R₄ are the same or different from one another and are each a hydrogen atom or an alkyl group of 1 to 4 carbon atoms.

The negative radiation-sensitive resin composition for the upper layer (II) preferably includes a polymer having a carboxyl group and/or a phenolic hydroxyl group (C), a crosslinking agent (D), a radiation-activated radical polymerization initiator (E), and an organic solvent (F). The polymer (C) preferably has a glass transition temperature (Tg) of not less than 40°C.

A transfer film according to the present invention comprises the two-layer laminated film and a support film on which the two-layer laminated film is provided.

A process for forming bumps on electrode pads on a wiring board comprises at least:
(a) a step of providing the laminated film on a substrate and forming a pattern of apertures at positions corresponding to electrode pads;
(b) a step of introducing a low-melting metal in the apertures;
(c) a step of reflowing the low-melting metal by heating to form bumps; and
(d) a step of peeling and removing the two-layer laminated film from the substrate.

In the step (b) of the bump-forming process, the low-melting metal may be introduced by applying a paste of low-melting metal or by directly mounting solder balls as will be described later.

Another process for forming bumps on electrode pads on a wiring board comprises at least:
(a) a step of providing the two-layer laminated film on a substrate and forming a pattern of apertures at positions corresponding to electrode pads;
(b') a step of introducing a low-melting metal in the apertures;
(d') a step of peeling and removing the two-layer laminated film from the substrate; and
(c') a step of reflowing the low-melting metal by heating to form bumps.

In the step (b') of this bump-forming process, the low-melting metal may be introduced by electrolytic deposition as will be described later.

### EFFECTS OF THE INVENTION

The negative radiation-sensitive laminated film for forming bumps is easily peeled and removed after bumps are formed. The two-layer laminated film is patternable with good configuration, permits excellent printing of a solder paste, and is easily peeled from a substrate. The processes of the invention are capable of efficiently forming bumps with good configuration.

### BRIEF DESCRIPTION OF THE DRAWINGS

Fig. 1 is a schematic sectional view illustrating a process of bump formation according to the present invention;
Fig. 2 is a schematic sectional view illustrating a process of bump formation according to the present invention;
Fig. 3 is a schematic sectional view illustrating a process of bump formation according to the present invention;
Fig. 4 is a schematic sectional view illustrating a process of bump formation according to the present invention;
Fig. 5 is a schematic sectional view illustrating a process of bump formation according to the present invention; and
Fig. 6 is a schematic sectional view illustrating a process of bump formation according to the present invention.

### DESCRIPTION OF THE CODES

101: electrode pad, 102: passivation film, 103: silicon substrate, 104: metal diffusion preventing film, 105: barrier metal, 106: lower layer, 107: upper layer, 108: bump-forming aperture, 109: squeegee, 110: low-melting metal paste, 111: reflowed low-melting metal bump,
201: electrode pad, 202: passivation film, 203: silicon substrate, 204: metal diffusion preventing film, 205: barrier metal, 206: lower layer, 207: upper layer, 208: bump-forming aperture, 209: low-melting metal ball, 210: reflowed low-melting metal bump,
301: electrode pad, 302: passivation film, 303: silicon substrate, 304: metal diffusion preventing film, 305: barrier metal, 306: upper layer, 307: lower layer, 308: bump-forming aperture, 309: electroplated low-melting metal film, 310: reflowed low-melting metal bump,
401: electrode pad, 402: insulating resin interlayer, 403: conductive circuit, 404: substrate, 405: via hole, 406: solder resist, 407: upper layer, 408: solder bump-forming aperture, 409: low-melting metal paste, 410: squeegee, 411: reflowed low-melting metal, 412: lower layer,
509: low-melting metal ball
609: electrodeposited low-melting metal film

### PREFERRED EMBODIMENTS OF THE INVENTION

The present invention will be described in detail below.

### Lower layer composition

The resin composition for the lower layer of the bump-forming laminated film according to the present invention is a radiation-nonsensitive resin composition including a polymer (A) with a specific structural unit, and an organic solvent (B).

### [Polymer (A)]

The polymer (A) in the radiation-nonsensitive resin composition has a structural unit represented by Formula (1) :

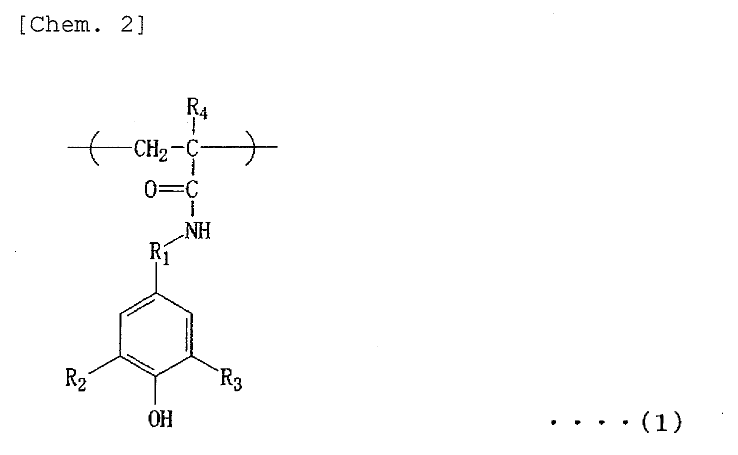

wherein R₁ is - (CH₂)ₙ- where n is an integer of 0 to 3, and R₂, R₃ and R₄ are each a hydrogen atom or an alkyl group of 1 to 4 carbon atoms.

The polymer (A) having the structural unit of Formula (1) shows high solubility in alkaline solutions. The lower layer is composed of the composition containing the polymer (A), and consequently the bump-forming two-layer laminated film exhibits excellent alkali developability and is satisfactorily patterned by being photoexposed and developed one time.

The structure of Formula (1) contains a phenolic hydroxyl group, which deactivates photo-radicals. The lower layer is composed of the composition containing the polymer (A), and consequently curing of the lower layer is inhibited even when the bump-forming two-layer laminated film is photoexposed, permitting good peelability of the laminated film.

The polymer having the structure of Formula (1) has low compatibility with a polymer (C) in the upper layer which will be described later. Consequently, intermixing of the upper and lower layers is inhibited and the laminated film is easily peeled. As used herein, the term intermixing refers to mixing together of the components of the upper and lower layers.

The polymer (A) having the structural unit of Formula (1) may be produced by (co) polymerizing a monomer (hereinafter, the monomer (1')) represented by the following formula:

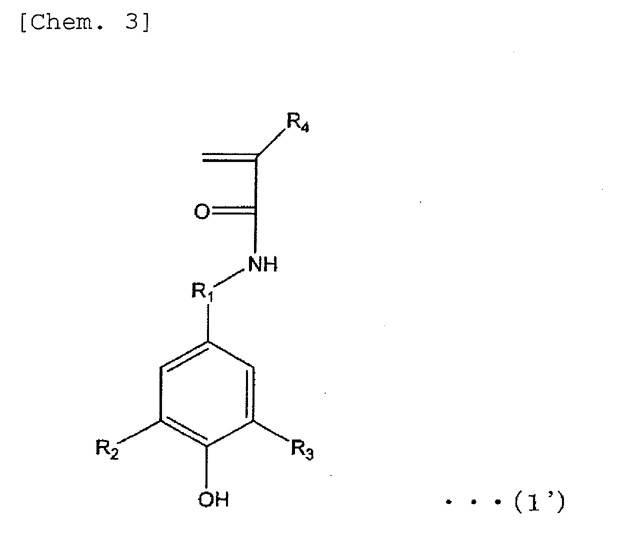

wherein R₁ is -(CH₂)ₙ- where n is an integer of 0 to 3, and R₂, R₃ and R₄ are each a hydrogen atom or an alkyl group of 1 to 4 carbon atoms.

Examples of the monomers (1') include
N-(p-hydroxyphenyl)acrylamide,
N-(p-hydroxyphenyl)methacrylamide,
N-(p-hydroxybenzyl)acrylamide,
N-(p-hydroxybenzyl)methacrylamide,
N-(3,5-dimethyl-4-hydroxybenzyl)acrylamide,
N-(3,5-dimethyl-4-hydroxybenzyl)methacrylamide,
N-(3,5-tert-butyl-4-hydroxybenzyl)acrylamide and
N-(3,5-tert-butyl-4-hydroxybenzyl)methacrylamide.

Of the monomers (1'), N-(p-hydroxyphenyl)acrylamide,
N-(p-hydroxyphenyl)methacrylamide,
N-(3,5-dimethyl-4-hydroxybenzyl)acrylamide and
N-(3,5-dimethyl-4-hydroxybenzyl)methacrylamide are preferred.

The monomers (1') may be used singly or in combination of two or more kinds.

The polymer (A) may be a copolymer of the monomer (1') and a copolymerizable monomer (hereinafter, the monomer (2')).

Examples of the monomers (2') include:
aromatic vinyl compounds such as o-hydroxystyrene, m-hydroxystyrene, p-hydroxystyrene, p-isopropenylphenol, styrene, α-methylstyrene, p-methylstyrene and p-methoxystyrene;
heteroatom-containing alicyclic vinyl compounds such as N-vinylpyrrolidone and N-vinylcaprolactam;
cyano group-containing vinyl compounds such as acrylonitrile and methacrylonitrile;
conjugated diolefins such as 1,3-butadiene and isoprene;
amide group-containing vinyl compounds such as acrylamide and methacrylamide;
carboxyl group-containing vinyl compounds such as acrylic acid and methacrylic acid; and
(meth)acrylates such as methyl (meth)acrylate, ethyl (meth)acrylate, n-propyl (meth)acrylate, n-butyl (meth)acrylate, 2-hydroxyethyl (meth)acrylate, 2-hydroxypropyl (meth)acrylate, polyethylene glycol mono (meth) acrylate, polypropylene glycol mono (meth) acrylate, glycerol mono(meth)acrylate, phenyl (meth)acrylate, benzyl (meth)acrylate, cyclohexyl (meth)acrylate, isobornyl (meth)acrylate and tricyclodecanyl (meth)acrylate.

The amount of the structural unit of Formula (1) in the polymer (A) is not particularly limited while achieving the effects of the present invention. The structural unit generally accounts for 5 to 100% by weight, preferably 20 to 100% by weight, more preferably 40 to 100% by weight of the polymer.

This amount of the structural unit of Formula (1) permits the polymer (A) to show superior solubility in alkaline solutions, high capability of deactivating photo-radicals, and adequately low compatibility with a polymer (C) (described later).

The types and amounts of the monomers (2') may be selected appropriately for increasing the adhesion of the lower layer, controlling the rate of dissolution in alkali, and inhibiting the intermixing of the upper and lower layers.

If the lower layer dissolves with alkali much faster than the upper layer, the two-layer laminated film will have apertures in undercut shape. If the lower layer dissolves with alkali much slower than the upper layer, the lower layer will be tailing shape.

The polymer (A) may be produced by radical polymerization. The polymerization methods include emulsion polymerization, suspension polymerization, solution polymerization and bulk polymerization. The solution polymerization is preferable.

The radical polymerization may be induced using common radical polymerization initiators, with examples including azo compounds such as 2,2'-azobisisobutyronitrile (AIBN) and 2,2'-azobis-(2,4-dimethylvaleronitrile), and organic peroxides such as benzoyl peroxide, lauryl peroxide and t-butyl peroxide.

The solvents for use in the solution polymerization are not particularly limited as long as they do not react with the monomers used and can dissolve the polymer produced. Examples of the solvents include methanol, ethanol, n-hexane, toluene, tetrahydrofuran, 1,4-dioxane, ethyl acetate, n-butyl acetate, acetone, methyl ethyl ketone, methyl isobutyl ketone, 2-heptanone, cyclohexanone, ethylene glycol monomethyl ether, propylene glycol monomethyl ether, propylene glycol monomethyl ether acetate, methyl 3-methoxypropionate, ethyl 3-ethoxypropionate, ethyl lactate and γ-butyrolactone. The solvents may be used singly or in combination of two or more kinds.

The solution polymerization produces a solution of the polymer (A) . The polymer solution may be used as it is in the preparation of the radiation-nonsensitive resin composition. Alternatively, the polymer (A) may be separated from the polymer solution and the polymer separated may be used in the preparation of the radiation-nonsensitive resin composition.

The polymerization may involve molecular weight modifiers such as mercaptan compounds and halogenated hydrocarbons as required.

The molecular weight of the polymer (A) may be controlled by appropriately selecting polymerization conditions such as monomer amounts, radical polymerization initiators, molecular weight modifiers and polymerization temperature. The weight-average molecular weight in terms of polystyrene (hereinafter, Mw) of the polymer (A) is generally in the range of 1, 000 to 100,000, preferably 5, 000 to 30, 000. The polymer (A) having this Mw shows excellent alkali solubility after photoexposed, and the solubility of the lower and upper layers is easily balanced.

The polymers (A) may be used singly or in combination of two or more kinds.

### [Organic solvent (B)]

The radiation-nonsensitive resin composition contains an organic solvent (B) so that the polymer (A) and other components such as compounds containing a phenolic hydroxyl group, acrylic resins and surfactants which will be described later are uniformly mixed or so that they give a satisfactory film.

Examples of the organic solvents (B) include ethylene glycol monomethyl ether, ethylene glycol monoethyl ether, ethylene glycol monomethyl ether acetate, ethylene glycol monoethyl ether acetate, diethylene glycol monomethyl ether, diethylene glycol monoethyl ether, propylene glycol monomethyl ether acetate, propylene glycol monopropyl ether acetate, toluene, xylene, methyl ethyl ketone, 2-heptanone, 3-heptanone, 4-heptanone, cyclohexanone, ethyl 2-hydroxypropionate, ethyl 2-hydroxy-2-methylpropionate, ethyl ethoxyacetate, ethyl hydroxyacetate, methyl 2-hydroxy-3-methylbutanoate, methyl 3-methoxypropionate, ethyl 3-ethoxypropionate, ethyl 3-methoxypropionate, butyl acetate, methyl pyruvate and ethyl pyruvate.

High-boiling solvents are also usable, with examples including N-methylformamide, N,N-dimethylformamide, N-methylformanilide, N-methylacetamide, N,N-dimethylacetamide, N-methylpyrrolidone, dimethyl sulfoxide, benzyl ethyl ether, dihexyl ether, acetonylacetone, isophorone, caproic acid, caprylic acid, 1-octanol, 1-nonanol, benzyl alcohol, benzyl acetate, ethyl benzoate, diethyl oxalate, diethyl maleate, γ-butyrolactone, ethylene carbonate, propylene carbonate and ethylene glycol monophenyl ether acetate.

Of the organic solvents (B), ethyl 2-hydroxypropionate, propylene glycol monomethyl ether acetate and 2-heptanone are preferable. The solvents (B) may be used singly or in combination of two or more kinds.

The amount of the organic solvents (B) may be determined in view of the application method and use of the composition, and is not particularly limited as long as the components of the composition are mixed uniformly. The amount of the organic solvents (B) is generally in the range of 5 to 50 parts by weight, preferably 10 to 40 parts by weight based on 100 parts by weight of the polymer (A) and the organic solvents (B) combined.

### [Compounds containing phenolic hydroxyl group]

The radiation-nonsensitive resin composition may contain a compound containing a phenolic hydroxyl group, to control the alkali dissolution rate and to prevent intermixing of the lower and upper layers.

The compounds containing a phenolic hydroxyl group are broadly divided into low-molecular weight compounds having up to 10 phenol skeletons, and high-molecular weight polymers such as novolak resins and poly(4-hydroxystyrene).

Examples of the low-molecular weight compounds include 4,4'-[1-[4-[1-(4-hydroxyphenyl)-1-methylethyl]phenyl] ethylidene]diphenol, methyl 2,2-bis(1,5-dimethyl-4-hydroxyphenyl)propionate and 4,6-bis[1-(4-hydroxyphenyl)-1-methylethyl]-1,3-benzenediol.

Compounds generally used as thermal polymerization inhibitors may also be used as the low-molecular weight compounds. Examples thereof include pyrogallol, benzoquinone, hydroquinone, methylene blue, tert-butylcatechol, monobenzyl ether, methylhydroquinone, amylquinone, amyloxyhydroquinone, n-butylphenol, phenol, hydroquinone monopropyl ether, 4,4'-(1-methylethylidene)bis(2-methylphenol), 4,4'-(1-methylethylidene)bis(2,6-dimethylphenol), 4, 4', 4" -ethylidene tris(2-methylphenol), 4,4',4"-ethylidene trisphenol and 1,1,3-tris (2,5-dimethyl-4-hydroxyphenyl)-3-phenylpropane.

Examples of the high-molecular weight polymers include novolak resins, polyhydroxystyrenes and derivatives thereof described below. They may be used singly or in combination.

### (Novolak resins)

The present invention may employ alkali-soluble novolak resins that are condensation products of m-cresol, one or more other phenols, and an aldehyde compound. The alkali-soluble novolak resins are not particularly limited as long as m-cresol accounts for 50 to 90 mol% of the phenols combined.

Examples of the other types of phenols as materials of the novolak resins include 2,3-xylenol, 2,4-xylenol, 2,5-xylenol, 3,4-xylenol, 3,5-xylenol and 2,3,5-trimethylphenol. Of these, 2,3-xylenol, 2,4-xylenol, 3,4-xylenol and 2,3,5-trimethylphenol are preferable. The phenols may be used singly or in combination or two or more kinds.

Preferred examples of m-cresol/phenol(s) combinations include m-cresol/2,3-xylenol, m-cresol/2,4-xylenol, m-cresol/2,3-xylenol/3,4-xylenol, m-cresol/2,3,5-trimethylphenol and m-cresol/2,3-xylenol/2,3,5-trimethylphenol.

The aldehyde compounds for use in the condensation include formaldehyde, paraformaldehyde, acetaldehyde, benzaldehyde, o-hydroxybenzaldehyde, m-hydroxybenzaldehyde, p-hydroxybenzaldehyde, glyoxal, glutaraldehyde, terephthalaldehyde and isophthalaldehyde. Of these, formaldehyde and o-hydroxybenzaldehyde are particularly suitable. The aldehydes may be used singly or in combination or two or more kinds. The amount of the aldehyde compounds is preferably in the range of 0.4 to 2 mol, more preferably 0.6 to 1.5 mol per mol of the phenols.

The condensation between the phenols and the aldehyde compounds is usually carried out in the presence of an acid catalyst. Examples of the acid catalysts include hydrochloric acid, nitric acid, sulfuric acid, formic acid, oxalic acid, acetic acid, methanesulfonic acid and p-toluenesulfonic acid. Generally, the acid catalyst may be used in an amount of 1x10⁻⁵ to 5x10⁻¹ mol per mol of the phenols.

The condensation is usually performed using water as reaction medium. When it is expected that the reaction system will be heterogeneous from an early stage of the reaction, the water as the reaction medium may be replaced by:
alcohols such as methanol, ethanol, propanol, butanol and propylene glycol monomethyl ether;
cyclic ethers such as tetrahydrofuran and dioxane; and
ketones such as ethyl methyl ketone, methyl isobutyl ketone and 2-heptanone. The amount of the reaction media may be in the range of 20 to 1,000 parts by weight per 100 parts by weight of the reactants.

Although the condensation temperature may be appropriately adjusted depending on the reactivity of the reactants, it is generally in the range of 10 to 200°C.

The condensation reaction may be carried out in an appropriate manner. For example, the phenols, aldehyde compounds, acid catalyst, etc. may be introduced all at once. Alternatively, the phenols, aldehyde compounds, etc. may be added with progress of the reaction in the presence of the acid catalyst.

After completion of the condensation, the unreacted materials, the acid catalyst, the reaction medium, etc. are removed from the system to recover the novolak resin. For example, the novolak resin may be recovered through a process (1) in which the temperature in the reaction system is increased to 130 to 230°C and the volatile components are evaporated under reduced pressure. Alternative is a process (2) in which the novolak resin obtained is dissolved in a good solvent, followed by mixing with a poor solvent such as water, n-hexane or n-heptane, and the precipitated resin solution phase is separated. The good solvents include ethylene glycol monomethyl ether acetate, methyl 3-methoxypropionate, ethyl lactate, methyl isobutyl ketone, 2-heptanone, dioxane, methanol and ethyl acetate.

The novolak resins preferably have Mw in the range of 2, 000 to 20, 000, particularly preferably 3, 000 to 15, 000 from the viewpoints of workability of the composition into films, and developability, sensitivity and heat resistance of the resists.

### (Polyhydroxystyrenes)

Suitable polyhydroxystyrenes for use in the invention include resins commercially available under the trade names of MARUKA LYNCUR M, MARUKA LYNCUR CMM, MARUKA LYNCUR CHM, MARUKA LYNCUR MB, MARUKA LYNCUR PHM-C, MARUKA LYNCUR CST and MARUKA LYNCUR CBA (manufactured by Maruzen Petrochemical Co., Ltd.) .

### [Acrylic resins]

The radiation-nonsensitive resin composition may contain an alkali soluble acrylic resin to improve application properties and to stabilize properties of films.

The composition of the acrylic resins is not particularly limited as long as the resins are soluble in alkali. For example, the alkali solubility is provided by units derived from (meth)acrylates in combination with units derived from monomers with a carboxyl group and/or monomers with a phenolic hydroxyl group.

Examples of the monomers with a carboxyl group include acrylic acid and methacrylic acid.

Examples of the monomers with a phenolic hydroxyl group include vinyl monomers with a phenolic hydroxyl group, such as p-hydroxystyrene, m-hydroxystyrene, o-hydroxystyrene, α-methyl-p-hydroxystyrene, α-methyl-m-hydroxystyrene, α-methyl-o-hydroxystyrene, 4-isopropenylphenol, 2-allylphenol, 4-allylphenol, 2-allyl-6-methylphenol, 2-allyl-6-methoxyphenol, 4-allyl-2-methoxyphenol, 4-allyl-2,6-dimethoxyphenol and 4-allyloxy-2-hydroxybenzophenone. Of the monomers, p-hydroxystyrene and 4-isopropenylphenol are preferred.

These monomers may be used singly or in combination of two or more kinds. The units derived from monomers with a carboxyl group and/or monomers with a phenolic hydroxyl group generally account for 1 to 60% by weight, preferably 5 to 50% by weight of the acrylic resin. When the amount is in this range, the resin film is developed to form a pattern with excellent configuration and is peeled easily after bumps are formed.

### [Surfactants]

The radiation-nonsensitive resin composition may contain a surfactant to improve application, anti-foaming and leveling properties.

Suitable surfactants include fluorine-containing surfactants commercially available under the trade names of NBX-15 (manufactured by NEOS); BM-1000 and BM-1100 (manufactured by BM Chemie) ; MEGAFACE series F142D, F172, F173 and F183 (manufactured by Dainippon Ink and Chemicals, Incorporated); FLUORAD series FC-135, FC-170C, FC-430 and FC-431 (manufactured by Sumitomo 3M); SURFLON series S-112, S-113, S-131, S-141 and S-145 (manufactured by Asahi Glass Co., Ltd.); and SH-28PA, SH-190, SH-193, SZ-6032 and SF-8428 (manufactured by Toray Dow Corning Silicone Co., Ltd.). The amount of the surfactants is preferably not more than 5 parts by weight per 100 parts by weight of the copolymer (A).

### [Other components]

The radiation-nonsensitive resin composition may contain other components such as resins and additives as described below.

The resins include phenol novolak epoxy resins, cresol novolak epoxy resins, bisphenol epoxy resins, trisphenol epoxy resins, tetraphenol epoxy resins, phenol-xylylene epoxy resins, naphthol-xylylene epoxy resins, phenol-naphthol epoxy resins, phenol-dicyclopentadiene epoxy resins and alicyclic epoxy resins.

The additives include inorganic fillers such as silica, aluminum hydroxide and barium sulfate, polymer additives, reactive diluents, leveling agents, wetting agents, plasticizers, antioxidants, antistatic agents, fungicides, moisture conditioners and flame-retardants.

### Upper layer composition

The composition for the upper layer of the bump-forming two-layer laminated film is a negative radiation-sensitive resin composition. Examples of the negative radiation-sensitive resin compositions include radiation-sensitive resin compositions as described in JP-A-H08-301911.

The negative radiation-sensitive resin composition preferably contains a polymer having a carboxyl group and/or a phenolic hydroxyl group (C), a crosslinking agent (D), a radiation-activated radical polymerization initiator (E) and a solvent (F). The bump-forming upper layer composed of the composition has alkali solubility and forms a pattern with excellent configuration efficiently by being photoexposed and developed one time.

### [Polymer having carboxyl group and/or phenolic hydroxyl group (C)]

The negative radiation-sensitive resin composition contains a polymer having a carboxyl group and/or a phenolic hydroxyl group (C). The polymer (C) gives alkali solubility to the resin composition. The polymer may be obtained by (co)polymerizing a monomer with a carboxyl group and/or a monomer with a phenolic hydroxyl group.

Examples of the monomers with a phenolic hydroxyl group include vinyl compounds with a phenolic hydroxyl group, such as p-hydroxystyrene, m-hydroxystyrene, o-hydroxystyrene, α-methyl-p-hydroxystyrene, α-methyl-m-hydroxystyrene, α-methyl-o-hydroxystyrene, 4-isopropenylphenol, 2-allylphenol, 4-allylphenol, 2-allyl-6-methylphenol, 2-allyl-6-methoxyphenol, 4-allyl-2-methoxyphenol, 4-allyl-2,6-dimethoxyphenol and 4-allyloxy-2-hydroxybenzophenone.

Examples of the monomers with a carboxyl group include carboxyl group-containing vinyl compounds such as acrylic acid and methacrylic acid.

These compounds may be used singly or in combination of two or more kinds. Of the monomers, p-hydroxystyrene and 4-isopropenylphenol are preferred.

The polymer (C) may be copolymerized with a copolymerizable monomer (hereinafter, the monomer (3')) other than the monomers with a phenolic hydroxyl group.

Examples of the monomers (3') include:
amide group-containing vinyl compounds such as acrylamide, methacrylamide, N-(p-hydroxyphenyl)acrylamide, N-(p-hydroxyphenyl)methacrylamide, N-(p-hydroxybenzyl)acrylamide and N-(p-hydroxybenzyl)methacrylamide; and
(meth)acrylates such as methyl (meth)acrylate, ethyl (meth)acrylate, n-propyl (meth)acrylate, n-butyl (meth)acrylate, 2-hydroxyethyl (meth)acrylate, 2-hydroxypropyl (meth)acrylate, polyethylene glycol mono (meth) acrylate, polypropylene glycol mono (meth) acrylate, glycerol mono(meth)acrylate, phenyl (meth)acrylate, benzyl (meth)acrylate, cyclohexyl (meth)acrylate, isobornyl (meth)acrylate, tricyclodecanyl (meth)acrylate and 8-tricyclo[5.2.1.0^{2.6}]decanyl methacrylate.

The units derived from monomers with a carboxyl group and monomers with a phenolic hydroxyl group generally account for 1 to 60% by weight, preferably 5 to 50% by weight of the polymer (C). When the amount is in this range, the resin film is developed to form a pattern with excellent configuration and is peeled easily after bumps are formed. The polymer (C) may be produced by radical polymerization. The polymerization methods include emulsion polymerization, suspension polymerization, solution polymerization and bulk polymerization. The solution polymerization is preferable. The radical polymerization may be induced using common radical polymerization initiators.

The radical polymerization initiators, solvents and molecular weight modifiers used in the polymerization of the polymer (C) are as described in the production of the polymer (A).

The molecular weight of the polymer (C) may be controlled by appropriately selecting polymerization conditions such as monomer amounts, radical polymerization initiators, molecular weight modifiers and polymerization temperature. The weight-average molecular weight in terms of polystyrene (Mw) of the polymer (C) is generally in the range of 2, 000 to 30, 000, preferably 4,000 to 10,000.

The polymer (C) preferably has a glass transition temperature (Tg) of not less than 40°C. If the polymer's Tg is less than 40°C, the upper layer becomes extremely sticky to cause difficult handling. Specifically, printing properties are drastically deteriorated when a solder paste is applied in apertures. The glass transition temperature (Tg) of the polymer (C) may be controlled by appropriately selecting polymerization conditions such as monomer amounts, radical polymerization initiators, molecular weight modifiers and polymerization temperature. The glass transition temperature of the polymer (C) may be determined with DSC (differential scanning calorimeter).

### [Crosslinking agent (D)]

The negative radiation-sensitive resin composition contains a crosslinking agent (D).

Examples of the crosslinking agents (D) include trimethylolpropane tri(meth)acrylate, pentaerythritol tri(meth)acrylate, ethylene glycol di(meth)acrylate, tetraethylene glycol di(meth)acrylate, polyethylene glycol di(meth)acrylate, 1,4-butanediol di(meth)acrylate, butylene glycol di(meth)acrylate, propylene glycol di(meth)acrylate, trimethylolpropane di(meth)acrylate, 1,6-hexanediol di(meth)acrylate, neopentyl glycol di(meth)acrylate, trimethylolpropane tri(meth)acrylate, tris(2-hydroxyethyl)isocyanurate tri(meth)acrylate, tris(2-hydroxyethyl) isocyanurate di(meth)acrylate, tricyclodecanedimethanol di(meth)acrylate, epoxy (meth)acrylate obtained by adding (meth)acrylic acid to diglycidyl ether of bisphenol A, bisphenol A-di(meth)acryloyloxyethyl ether, bisphenol A-di(meth)acryloyloxy ethyloxy ethyl ether, bisphenol A-di(meth)acryloyloxyloxy methyl ethyl ether, tetramethylolpropane tetra(meth)acrylate, pentaerythritol tri(meth)acrylate, pentaerythritol tetra(meth)acrylate, dipentaerythritol penta(meth)acrylate and dipentaerythritol hexa(meth)acrylate.

Commercially available compounds may be used as the crosslinking agents (D). Examples thereof include compounds commercially available under the trade names of ARONIX series M-210, M-309, M-310, M-400, M-7100, M-8030, M-8060, M-8100, M-9050, M-240, M-245, M-6100, M-6200, M-6250, M-6300, M-6400 and M-6500 (manufactured by Toagosei Co., Ltd.); KAYARAD series R-551, R-712, TMPTA, HDDA, TPGDA, PEG400DA, MANDA, HX-220, HX-620, R-604, DPCA-20, DPCA-30, DPCA-60 and DPCA-120 (manufactured by Nippon Kayaku Co., Ltd.); and Biscoat series Nos. 295, 300, 260, 312, 335HP, 360, GPT, 3PA and 400 (manufactured by Osaka Organic Chemical Industry Ltd.).

The crosslinking agents (D) may be used singly or in combination of two or more kinds. The amount of the crosslinking agents is preferably in the range of 10 to 250 parts by weight, more preferably 20 to 200 parts by weight, particularly preferably 25 to 150 parts by weight based on 100 parts by weight of the polymer (C). When the amount of the crosslinking agents (D) is in this range, the resin composition obtained shows high sensitivity and contrast in the photoexposure, high compatibility of the crosslinking agent with the polymer (C), excellent storage stability and superior peeling properties.

### [Radiation-activated radical polymerization initiator (E)]

The negative radiation-sensitive resin composition contains a radiation-activated radical polymerization initiator (E).

Examples of the radiation-activated radical polymerization initiators (E) include:
α-diketones such as benzyl and diacetyl;
acyloins such as benzoin;
acyloin ethers such as benzoin methyl ether, benzoin ethyl ether and benzoin isopropyl ether;
benzophenones such as thioxanthone, 2,4-diethyl thioxanthone, thioxanthone-4-sulfonic acid, benzophenone, 4,4'-bis(dimethylamino)benzophenone and 4,4'-bis(diethylamino)benzophenone;
acetophenones such as acetophenone, p-dimethylaminoacetophenone, α,α-dimethoxy-α-acetoxybenzophenone, α,α-dimethoxy-α-phenylacetophenone, p-methoxyacetophenone, 1-[2-methyl-4-methylthiophenyl]-2-morpholino-1-propanone, α,α-dimethoxy-α-morpholino-methylthiophenyl acetophenone and 2-benzyl-2-dimethylamino-1-(4-morpholinophenyl)-butane-1-one;
quinones such as anthraquinone and 1,4-naphthoquinone; halides such as phenacyl chloride, tribromomethylphenylsulfone and tris(trichloromethyl)-s-triazine;
bisimidazoles such as [1,2'-bisimidazole]-3,3' ,4,4'-tetraphenyl and [1,2'-bisimidazole]-1,2'-dichlorophenyl-3,3' ,4,4'-tetraphenyl;
peroxides such as di-tert-butyl peroxide; and
acylphosphine oxides such as 2,4,6-trimethylbenzoyldiphenylphosphine oxide.

Commercially available initiators include IRGACURE series 184, 651, 500, 907, CGI369 and CG24-61 (manufactured by Ciba Specialty Chemicals Inc.) ; LUCIRIN LR8728 and LUCIRIN TPO (manufactured by BASF); DAROCUR series 1116 and 1173 (manufactured by Ciba Specialty Chemicals Inc.); and UBECRYL P36 (manufactured by UCB).

Where necessary, the above radiation-activated radical polymerization initiators may be used in combination with hydrogen donor compounds such as mercaptobenzothiazole and mercaptobenzoxazole.

Of the radiation-activated radical polymerization initiators, preferable are:
acetophenones such as 1-[2-methyl-4-methylthiophenyl]-2-morpholino-1-propanone, 2-benzyl-2-dimethylamino-1-(4-morpholinophenyl)-butane-1-o ne and α,α-dimethoxy-α-phenylacetophenone;
phenacyl chloride, tribromomethylphenylsulfone, 2,4,6-trimethylbenzoyldiphenylphosphine oxide;
combinations of the 1,2'-bisimidazoles and 4,4'-diethylaminobenzophenone and mercaptobenzothiazole;
LUCIRIN TPO, and IRGACURE 651.

These compounds may be used singly or in combination of two or more kinds. The amount of the initiators is generally in the range of 0.1 to 60 parts by weight, preferably 5 to 50 parts by weight, more preferably 10 to 40 parts by weight based on 100 parts by weight of the polymer (A). When the amount is in this range, the composition is less liable to be affected by the deactivation of radicals by oxygen (which causes deteriorated sensitivity), and compatibility and storage stability are excellent. The radiation-activated radical polymerization initiators may be used in combination with radiation sensitizers.

### [Organic solvent (F)]

The negative radiation-sensitive resin composition contains an organic solvent (F) so that the polymer (C), crosslinking agents (D) and radiation-activated radical polymerization initiators (E) are uniformly mixed or so that they give a satisfactory film. Examples of the organic solvents (F) are as described with respect to the organic solvents (B) . The organic solvents (F) may be used singly or in combination of two or more kinds.

The amount of the organic solvents (F) may be determined in view of the application method and use of the composition, and is not particularly limited as long as the components of the composition are mixed uniformly. The amount of the organic solvents (F) is generally in the range of 20 to 60 parts by weight, preferably 30 to 50 parts by weight based on 100 parts by weight of the upper layer composition.

### Bump-forming two-layer laminated film

The bump-forming two-layer laminated film of the invention includes the upper and lower layers having different properties, so that both high resolution and easy peeling are achieved. Specifically, the following effects are achieved:
(1) The lower layer has adequate alkali developability and is patterned by being photoexposed and developed one time.
(2) The phenolic hydroxyl group in the resin composition of the lower layer deactivates photo-radicals to inhibit curing reaction at the interface between the lower layer and the substrate. As a result, good peelability of the two-layer laminated film is ensured.
(3) The resin composition of the lower layer and the resin solution of the upper layer have low compatibility, and intermixing thereof is prevented. As a result, good peelability of the two-layer laminated film is ensured.
(4) The resin composition of the upper layer is a negative radiation-sensitive resin composition including an alkali soluble resin. As a result, the upper layer is patterned with excellent configuration efficiently by being photoexposed and developed one time.

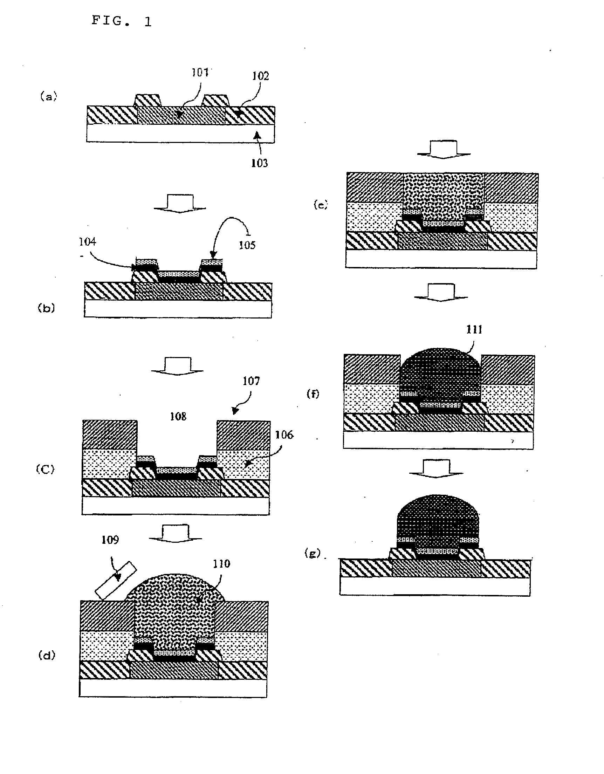

Consequently, the negative radiation-sensitive resin compositions traditionally unsuitable for use due to poor peelability may be used as materials of bump-forming laminated films. The upper layer made of the negative radiation-sensitive resin composition shows adequate mechanical strength by being subjected to additional treatments such as post-photoexposure and post-baking. Such increased mechanical strength of the resist pattern is required in the step of adding a low-melting metal paste 110 into a pattern of bump-forming apertures 108 as illustrated in Fig. 1 (e) .

Furthermore, the lower layer 106 has excellent peelability such that it can be peeled even by single use of a highly polar organic solvent such as dimethyl sulfoxide or N-methylpyrrolidone. The upper layer is crosslinked and is hardly soluble in such highly polar organic solvents. Therefore, the upper layer that is peeled may be easily removed by precipitation separation or cycle filtration.

The peeling may be performed with a peeling apparatus having multistage soaking baths. The treatment may be designed to peel most of the negative radiation-sensitive resin composition layer in the first bath containing an organic solvent, and to remove the residues of the lower layer in the second and later baths filled with a peeling solution containing an alkali component. Consequently, the peeling efficiency is improved without increasing the alkali concentration of the peeling solution, and the damages to the solder bumps and the underlying substrate are minimized.

### [Production of lower and upper layers]

The bump-forming two-layer laminated film according to the invention may be produced as follows. On a substrate having a predetermined wiring pattern, the lower layer is provided by applying the lower layer composition followed by drying, or by laminating the lower layer. Thereafter, the upper layer is provided by applying the upper layer composition followed by drying, or by laminating the upper layer. When the materials are liquid, the application may be performed by dipping, spin coating, roll coating or screen printing, or by use of an applicator or a curtain coater. When the materials are films, lamination or vacuum lamination may be adopted. Drying conditions for the lower and upper layers vary depending on the types and amounts of the components in the compositions, and the coating thickness. Generally, the drying is performed at temperatures in the range of 70 to 140°C for about 5 to 20 minutes, preferably at temperatures in the range of 80 to 130°C for about 2 to 10 minutes. The drying time and temperature in the above ranges provide excellent adhesion and resolution at development.

The lower layer and the upper layer may be laminated beforehand into a two-layer dry film and may be laminated on the substrate together. This two-layer dry film may be provided on the substrate by transferring the layers from a transfer film as described below.

### Transfer film

The transfer film according to the present invention includes the bump-forming two-layer laminated film on a support film. The transfer film may be manufactured by applying the upper layer composition on the support film followed by drying, and applying the lower layer composition followed by drying. Methods for applying the compositions include spin coating, roll coating, screen printing and use of applicators. The material of the support film is not particularly limited as long as it has strength enough to withstand stress in the manufacturing and use of the transfer film.

### Process for forming bumps

The process for forming bumps on electrode pads on a wiring board according to the invention includes at least:
(a) a step of providing the two-layer laminated film on a substrate and forming a pattern of apertures at positions corresponding to electrode pads;
(b) a step of introducing a low-melting metal in the apertures;
(c) a step of reflowing the low-melting metal by heating to form bumps; and
(d) a step of peeling and removing the two-layer laminated film from the substrate.

### [Step (a)]

The process of bump formation includes a step of forming a pattern. The patterning step includes steps of (i) forming the lower and upper layers, (ii) irradiation, and (iii) development.

### (i) Formation of lower and upper layers

The lower and upper layers may be formed as described hereinabove. They may be provided on the substrate using the transfer film described above.

### (ii) Irradiation

The two-layer laminated film obtained in the step (i) is irradiated to form a latent image of the pattern. The irradiation is performed as described below.

The two-layer laminated film is irradiated with ultraviolet rays or visible rays of 300 to 500 nm wavelength, through a mask having a predetermined pattern. Exemplary radiation sources include low-pressure, high-pressure and ultra high-pressure mercury lamps, metal halide lamps and argon gas lasers. As used herein, the radiations include ultraviolet rays, visible rays, far ultraviolet rays, X-rays and electron beams. The dose of radiation varies depending on the types and amounts of the components in the compositions, and the film thickness. For example, it is generally in the range of 100 to 2, 000 mJ/cm² in the case of ultra high-pressure mercury lamps.

### (iii) Development

After the step (ii), the pattern is developed as described below.

Unnecessary portions are dissolved and removed with an alkaline aqueous solution as a developer, while the irradiated portions remain. Examples of the developers include aqueous solutions of alkalis such as tetramethylammonium hydroxide, tetraethylammonium hydroxide, pyrrole, piperidine, 1,8-diazabicyclo[5.4.0]-7-undecene, 1,5-diazabicyclo[4.3.0]-5-nonane, ethylamine, n-propylamine, diethylamine, di-n-propylamine, triethylamine, methyldiethylamine, dimethylethanolamine, triethanolamine, sodium hydroxide, potassium hydroxide, sodium carbonate, sodium silicate, sodium metasilicate and ammonia water. Appropriate amounts of water-soluble organic solvents such as methanol and ethanol, and surfactants may be added to the alkaline aqueous solutions.

The development time varies depending on the types and amounts of the components in the compositions, and the dry film thickness. For example, it is usually in the range of 30 to 360 seconds. The developing methods include dropping, dipping, paddling and spraying. After the development, the patterned film is washed under running water for 30 to 90 seconds and is air dried using an air gun, dried in an oven, or spin dried using a spinner.

As a result of the development with the developing solution, the irradiated area of the upper layer remains and the lower layer is dissolved and removed correspondingly to the removed area (non-irradiated area) of the upper layer. The remaining laminated film (resist film) may be further cured by post-photoexposure or heating.

### [Step (b)]

The process of bump formation includes a step of introducing a low-melting metal. For example, a low-melting metal paste such as a solder paste is added into the apertures with use of a squeegee. Alternative methods include direct placement of solder balls and electrolytic deposition.

### [Step (c)]

The process of bump formation includes a step of reflowing the low-melting metal in the apertures by heating to form bumps.

### [Step (d)]

The bump-forming process includes a step of peeling and removing the two-layer laminated film from the substrate. The peeling and removal are performed as described below.

After the bumps are formed, the cured layers (resist layers) on the substrate are peeled by, for example, soaking the substrate in a peeling solution at 50 to 80°C with agitation for 5 to 30 minutes. Preferred peeling solutions used herein include dimethyl sulfoxide, and a mixed solution of quaternary ammonium salt, dimethyl sulfoxide and water. Small amounts of alcohols may be added to the peeling solutions.

Specifically, the two-layer laminated film may be peeled and removed from the substrate with use of a peeling apparatus having multistage soaking baths. The treatment may be designed to peel the two-layer laminated film in the first bath containing an appropriate organic solvent, followed by cycle filtration of the pieces peeled, and to peel the residual laminated film in the second and later baths filled with a peeling solution containing an organic alkali component. In particular, the treatment may be preferably designed to peel the two-layer laminated film in the first bath containing dimethyl sulfoxide or N-methylpyrrolidone, and to peel the residual laminated film in the second and later baths filled with a peeling solution containing an organic alkali component and dimethyl sulfoxide.

In another aspect, the process for forming bumps on electrode pads on a wiring board according to the invention includes at least:
(a) a step of providing the two-layer laminated film on a substrate and forming a pattern of apertures at positions corresponding to electrode pads;
(b) a step of introducing a low-melting metal in the apertures;
(d') a step of peeling and removing the two-layer laminated film from the substrate; and
(c') a step of reflowing the low-melting metal by heating to form bumps.

The steps (a), (b), (d') and (c') may be performed as described in the above process of bump formation.

### [Embodiments of bump-forming processes]

Hereinbelow, embodiments of the bump-forming processes according to the present invention will be described with reference to the drawings.

A first embodiment of the process for forming bumps on electrode pads according to the invention will be explained in great detail with reference to Fig. 1. Fig. 1(a) shows a sectional structure of a semiconductor chip wafer in which electrode pads 101 are arranged so as to form an area over the entire surface of the semiconductor. The electrode pads 101 are formed on the silicon substrate 103, the silicon substrate is covered with a passivation film 102 having a thickness of, for example, 1 µm, so as to expose the major surface of the electrode pads 101.

As illustrated in Fig. 1(b), an electrode metal diffusion preventing film 104 and a barrier metal film 105 are formed by sputtering or deposition. The metal diffusion preventing film 104 is formed of Ni, Cr, TiN, TaN, Ta, Nb or WN in a thickness of, for example, 1 µm. The metal diffusion preventing film 104 may be a single film or a laminated film. The barrier metal film 105 is formed by depositing a metal such as Ti, Ni or Pd in a thickness of several thousand angstroms.

As shown in Fig. 1(c), a two-layer laminated film is formed on the entire surface of the passivation film 102 and the barrier metal film 105. The two-layer laminated film includes a lower layer 106 comprising an alkali-soluble radiation-nonsensitive resin composition and an upper layer 107 comprising a negative radiation-sensitive resin composition.

For example, the lower layer 106 may be formed by applying a liquid lower layer material in a thickness of 2 to 3 µm. The upper layer 107 may be formed on the lower layer 106 by applying a liquid negative radiation-sensitive resin composition or laminating a negative radiation-sensitive dry film resist in a thickness of at least 50 µm. The laminated film consisting of the lower and the upper layers 106 and 107 is exposed to radiation through a mask and is developed to produce bump-forming apertures 108 at positions above the electrode pads 101 where bumps are to be formed. After the bump-forming apertures are created, the upper layer may be post-photoexposed and post-baked, and consequently crosslinking in the upper layer proceeds to increase the mechanical strength and solvent resistance.

Combinations of the resist layers of the two-layer laminated film are for example:
(1) a liquid resist for the lower layer, and a liquid resist for the upper layer;
(2) a liquid resist for the lower layer, and a dry film resist for the upper layer;
(3) a dry film resist for the lower layer, and a liquid resist for the upper layer;
(4) a dry film resist for the lower layer, and a dry film resist for the upper layer; and
(5) a two-layer dry film resist having a lower layer/upper layer structure.

As illustrated in Fig. 1(d), a low-melting metal paste 110 such as a solder paste is introduced in the bump-forming apertures with use of a squeegee 109 or the like.

Referring to Figs. 1 (e) and (f), the semiconductor wafer with the metal paste introduced therein is heated in a nitrogen atmosphere, and the metal paste is reflowed to produce bumps 111.

Subsequently, the laminated film is peeled as shown in Fig. 1 (g). The semiconductor wafer is electrically tested and diced into chips. The chips are subjected to flip chip bonding.

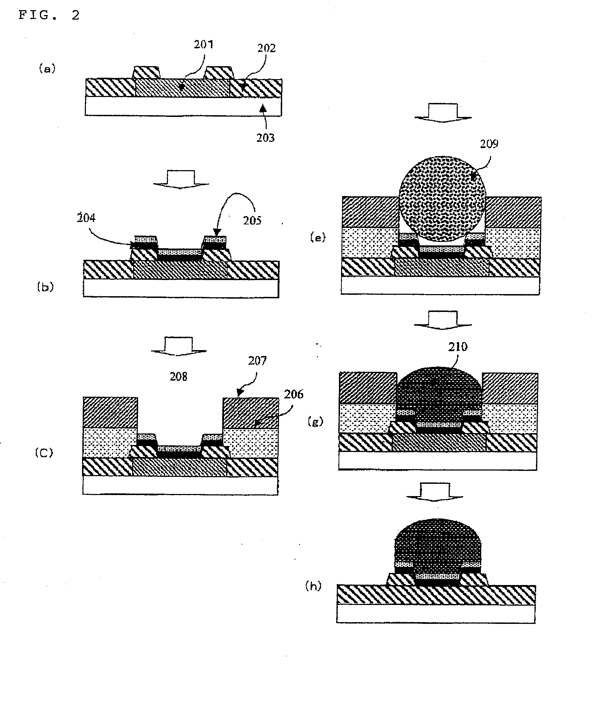

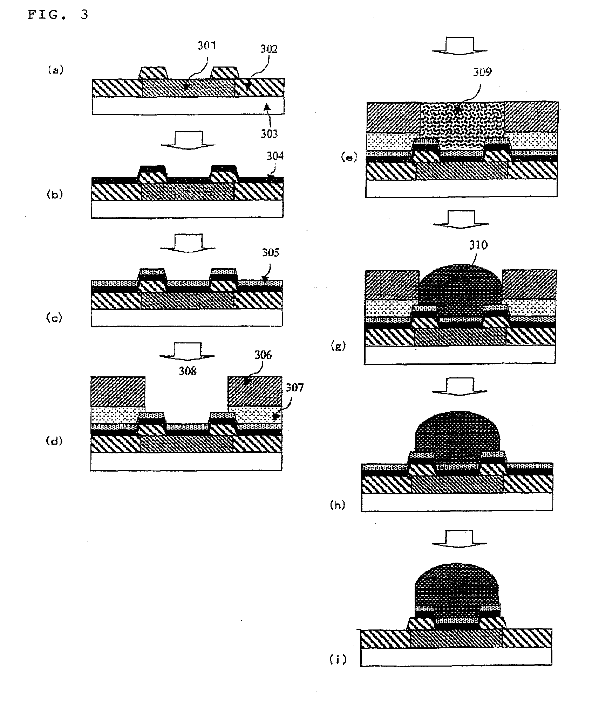

Although the above-described embodiment employs a solder paste as the low-melting metal paste, good reliability may be obtained by use of a mixture of metals such as Sn, Pb, Ag, Bi, Zn, In, Sb, Cu, Bi and Ge. In the above embodiment, the solder bumps are produced by filling the bump-forming apertures 108 with the paste with use of the squeegee. Alternatively, the bumps may be formed by placing low-melting metal balls 209 as shown in Fig. 2 (second embodiment) or by electrolytic deposition of solder to produce a low-melting metal film 309 as shown in Fig. 3 (third embodiment). When the low-melting metal film is electrolytically deposited (Fig. 3), the metal diffusion preventing film and/or the barrier metal film work as feeding films. Therefore, these films are generally formed on the entire surface of the substrate and are removed by wet etching or the like after reflowing other than below the bumps. Reflowing the metal paste may be followed by flux cleaning.

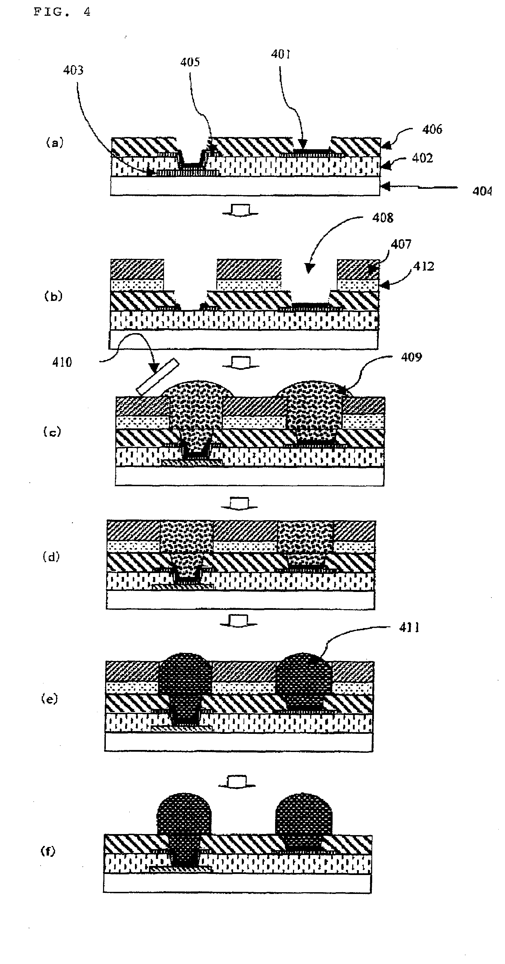

Figs. 4(a) to (f) illustrate formation of bumps on a multilayer printed wiring board by the process of the invention.

Although Fig. 4 shows one conductive circuit and one insulating resin interlayer, the multilayer printed wiring board generally has a plurality of these circuits and layers in alternate order.

A fourth embodiment of the process for forming bumps on electrode pads according to the invention will be explained with reference to Fig. 4. In the present embodiment, a wiring board comprises a plurality of electrode pads 401, and a solder resist 406 embedding the side surface of the electrode pads. The wiring board is provided on a substrate 404 comprising glass epoxy resin or BT (bismaleimide-triadine) resin, with an insulating resin interlayer 402 in between. Bump-forming apertures 408 are filled with a low-melting metal paste 409, typically a solder paste, with use of a squeegee 410.

Fig. 4 (a) shows a sectional structure of the wiring board in which the electrode pads 401 are arranged over the entire surface of the semiconductor. This wiring board is a multilayer laminated board that includes the insulating resin interlayer 402 and the conductive circuits 403 on the substrate 404 made of glass epoxy resin or BT (bismaleimide-triadine) resin. The conductance across the thickness of the board is obtained through via holes 405 formed on part of the wiring board by deposition. The solder resist 406 is applied over the insulating resin interlayer 402 and is developed to create apertures at positions corresponding to the electrodes. The conductive circuits are partially exposed at the bottom of the apertures, and the electrode pads 401 are formed on the exposed conductive circuits by, for example, electroless deposition. A two-layer laminated film composed of lower and upper layers 412 and 407 is provided thereon as described below.

The lower layer 412 may be formed by applying a liquid lower layer material in a thickness of 2 to 5 µm. The upper layer 407 may be formed thereon by applying a liquid negative radiation-sensitive resin composition or laminating a negative dry film resist in a thickness of at least 40 µm. The laminated film is photoexposed through a patterned mask and is developed to produce solder-bump-forming apertures 408.

Similarly to the aforementioned embodiment using the silicon wafer substrate, combinations of the resist layers of the two-layer laminated film are for example:
(1) a liquid resist for the lower layer, and a liquid resist for the upper layer;
(2) a liquid resist for the lower layer, and a dry film resist for the upper layer;
(3) a dry film resist for the lower layer, and a liquid resist for the upper layer;
(4) a dry film resist for the lower layer, and a dry film resist for the upper layer; and
(5) a two-layer dry film resist having a lower layer/upper layer structure.

As illustrated in Figs. 4(c) and (d), the bump-forming apertures are filled with the low-melting metal paste 409 such as a solder paste with use of the squeegee 410 or the like.

Referring to Fig. 4 (e), the semiconductor wafer with the metal paste introduced therein is heated in a nitrogen atmosphere, and the metal paste is reflowed to produce bumps.

Subsequently, the laminated film is peeled as shown in Fig. 4 (f) .

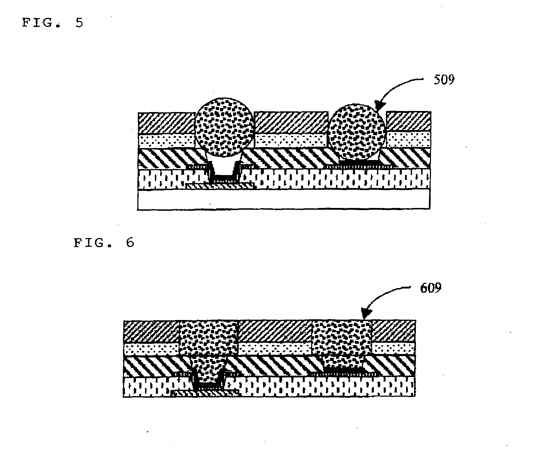

Although the above-described embodiment employs a solder paste as the low-melting metal paste, good reliability may be obtained by use of a mixture of metals such as Sn, Pb, Ag, Bi, Zn, In, Sb, Cu, Bi and Ge. In the above embodiment, the low-melting metal bumps, preferably solder bumps, are formed by filling the apertures with the metal paste with use of the squeegee. Alternatively, the bumps may be formed by placing low-melting metal balls (solder balls) 509 as shown in Fig. 5 (fifth embodiment) or by electrolytic deposition of a low-melting metal such as solder to produce a low-melting metal film 609 as shown in Fig. 6 (sixth embodiment). When the low-melting metal film is electrolytically deposited as shown in Fig. 6, the two-layer laminated film may be peeled and the metal may be reflowed. Reflowing the low-melting metal may be followed by flux cleaning.

### [Examples]

The present invention will be described in greater detail by examples below, but it should be construed that the invention is in no way limited thereto.

Components of lower layer compositions were as follows.

### <Synthesis of polymers (A)>

### [Synthetic Example 1]

### Synthesis of polymer A-1

A flask equipped with a dry ice/methanol reflux condenser and a thermometer was purged with nitrogen. The flask was charged with 100 g of N-(3,5-dimethyl-4-hydroxybenzyl) acrylamide and 300 g of methanol, followed by stirring. Subsequently, 4 g of AIBN was added, and polymerization was performed in refluxing methanol (64.5°C) with stirring for 8 hours. After the completion of the polymerization, the polymerization solution was cooled to room temperature and was poured into a large amount of water to precipitate the polymer. The polymer was redissolved in tetrahydrofuran and was reprecipitated in a large amount of hexane. These operations were repeated three times. The precipitated product was vacuum dried at 40°C for 48 hours to give a polymer A-1.

### [Synthetic Example 2]

### Synthesis of polymer A-2

A polymer A-2 was obtained by the same procedures as the polymer A-1 was synthesized, except that 100 g of N-(3,5-dimethyl-4-hydroxybenzyl)acrylamide was replaced by 90 g of N-(3,5-dimethyl-4-hydroxybenzyl)acrylamide and 10 g of styrene.

### [Synthetic Example 3]

### Synthesis of polymer A-3

A polymer A-3 was obtained by the same procedures as the polymer A-1 was synthesized, except that 100 g of N-(3,5-dimethyl-4-hydroxybenzyl)acrylamide was replaced by 65 g of N-(3,5-dimethyl-4-hydroxybenzyl)acrylamide, 15 g of styrene and 20 g of 2-hydroxyethyl acrylate.

### <Organic solvents (B)>

The following compounds were used as organic solvents (B) :
B-1: Ethyl 2-hydroxypropionate
B-2: Propylene glycol monomethyl ether acetate
B-3: 2-Heptanone

### <Additive resins>

The following resins were used as additive resins:
Additive resin 1: Polyhydroxystyrene (Mw: 3,000)
Additive resin 2: Hydroxystyrene/styrene copolymer (feeding weight ratio: 80/20, Mw: 1,200)
Additive resin 3: Formalin condensate of m-cresol and p-cresol (feeding weight ratio: 60/40, Mw: 1,200)
Additive resin 4: 4,4'-[1-[4[1-(4-Hydroxyphenyl)-1-methylethyl]phenyl]ethyli dene]diphenol
Components of upper layer compositions were as follows.

### <Synthesis of polymers having phenolic hydroxyl group (C)>

### [Synthetic Example 4]

### Synthesis of polymer C-1

A flask purged with nitrogen was charged with 10.0 g of dimethyl 2,2'-azobis(isobutyrate) as polymerization initiator and 150 g of ethyl 2-hydroxypropionate as solvent. They were stirred until the polymerization initiator was dissolved. Subsequently, 5.0 g of p-isopropenylphenol, 14 g of N-(P-hydroxyphenyl)methacrylamide, 12.0 g of methacrylic acid, 32 g of 8-tricyclo[5.2.1.0^{2.6}]decanyl methacrylate and 37.0 g of n-butyl methacrylate were introduced into the flask. They were stirred slowly to give a solution. The solution was heated to 80°C, and polymerization was carried out at the temperature for 3 hours. Additional 1.0 g of dimethyl 2,2'-azobis(isobutyrate) was added, and polymerization was performed at 80°C for 3 hours and at 110°C for 1 hour. The polymerization solution was allowed to cool to room temperature, and the gas in the flask was replaced with air. The solution was added dropwise to a large amount of methanol to precipitate the reaction product. The precipitated product was washed with water, redissolved in the same weight as the product of tetrahydrofuran, and reprecipitated in a large amount of methanol. The operations of redissolution through reprecipitation were carried out three times. The precipitated product was vacuum dried at 40°C for 48 hours to give a polymer C-1. Tg of the polymer C-1 was determined to be 98°C.
Tg measuring apparatus: (differential scanning calorimeter manufactured by TA Instruments)
Tg measuring conditions (measurement range: -80 to 500°C, heating rate: 5°C/min, nitrogen flow rate: 60 ml/min)

### [Synthetic Example 5]

### Synthesis of polymer C-2

A flask purged with nitrogen was charged with 4.0 g of 2,2'-azobis(isobutyronitrile) as polymerization initiator and 150 g of ethyl 2-hydroxypropionate as solvent. They were stirred until the polymerization initiator was dissolved. Subsequently, 10.0 g of methacrylic acid, 15.0 g of p-isopropenylphenol, 25 g of 8-tricyclo [5.2.1.0^{2.6}] decanyl methacrylate, 20 g of isobornyl acrylate and 30.0 g of n-butyl acrylate were introduced into the flask. They were stirred slowly to give a solution. The solution was heated to 80°C, and polymerization was carried out at the temperature for 3 hours. Additional 1.0 g of 2,2'-azobis(isobutyronitrile) was added, and polymerization was performed at 80°C for 3 hours and at 110°C for 1 hour. The polymerization solution was allowed to cool to room temperature, and the gas in the flask was replaced with air. The solution was added dropwise to a large amount of methanol to precipitate the reaction product. The precipitated product was washed with water, redissolved in the same weight as the product of tetrahydrofuran, and reprecipitated in a large amount of methanol. The operations of redissolution through reprecipitation were carried out three times . The precipitated product was vacuum dried at 40°C for 48 hours to give a polymer C-2. Tg of the polymer C-2 was determined to be 61°C in the same manner as for the polymer C-1.

### <Crosslinking agents (D)>

The following compounds were used as crosslinking agents (D) :
D-1: ARONIX M-8060 (manufactured by Toagosei Co., Ltd.)
D-2: ARONIX M-305 (manufactured by Toagosei Co., Ltd.)

### <Radiation-activated radical polymerization initiators (E) >

The following compounds were used as radiation-activated radical polymerization initiators (E):
E-1: IRGACURE 651 (manufactured by Ciba-Geigy Chemical Corporation)
E-2: LUCIRIN TPO (manufactured by BASF)
E-3: 2,2'-Bis(2,4-dichlorophenyl)-4,5,4',5'-tetraphenyl-1,2'-bi imidazole (manufactured by KUROGANE KASEI Co., Ltd.)

### <Organic solvents (F) >

The following compounds were used as organic solvents (F) :
F-1: Ethyl 2-hydroxypropionate
F-2: Propylene glycol monomethyl ether acetate
Lower layer compositions were prepared as follows.

### <Preparation of lower layer composition L-1>

As shown in Table 1, 25 parts of the polymer A-1, 75 parts of the organic solvent B-1 and 0.1 part of surfactant NBX-15 were mixed and stirred to give a uniform solution. The solution was filtered through a membrane filter having a pore size of 3 µm (capsule cartridge filter CCP-FX-C1B manufactured by ADVANTEC) . Consequently, a lower layer composition L-1 was obtained.

### <Preparation of lower layer compositions L-2 to L-5>

Lower layer compositions L-2 to L-5 were prepared in the same manner as the composition L-1, except that the components and amounts thereof were changed as shown in Table 1.

### <Preparation of comparative lower layer compositions CL-1 and CL-2>

Comparative lower layer compositions CL-1 and CL-2 were prepared in the same manner as the composition L-1, except that the components and amounts thereof were changed as shown in Table 1.

### <Preparation of lower layer transfer film LF-1>

A transfer film was prepared from the lower layer composition L-1 as follows. The lower layer composition L-1 was spin coated over an 11 cm-square polyethyleneterephthalate (PET) film having a thickness of 50 µm so that the dry film thickness would be 5 µm. The coating was dried in a convection oven at 100°C for 10 minutes.

[Table 1]

**Table 1**

| Lower layer compositions | | | | |
|---|---|---|---|---|
| Lower layer composition | State | Component A | Component B | Other components |
| | | Resin with skeleton of Formula 1 | Solvent | |
| L-1 | Liquid | A-1 (25 parts) | B-1 (75 parts) | SurfactantNBX-15 (0.1 part) |
| L-2 | Liquid | A-1 (25 parts) | B-2 (75 parts) | SurfactantNBX-15 (0.1 part) |
| L-3 | Liquid | A-2 (25 parts) | B-1 (75 parts) | SurfactantNBX-15 (0.1 part) |
| L-4 | Liquid | A-3 (25 parts) | B-1 (75 parts) | Surfactant NBX-15 (0.1 part) |
| L-5 | Liquid | A-1 (20 parts) A-1 (20 parts) | B-1 (75 parts) | Additive resin 1 (5 parts) SurfactantNBX-15 (0.1 part) |
| L-6 | Liquid | A-1 (15 parts) A-1 (15 parts) | B-1 (75 parts) | Additive resin 2 (10 parts) SurfactantNBX-15 (0.1 part) |
| LF-1 | Dry film | A-1 (100 parts) | B-1 (75 parts) | SurfactantNBX-15 (0.1 part) |
| CL-1 | Liquid | | B-2 (60 parts) | Additive resin 3 (32 parts) C-2 (8 parts) Surfactant NBX-15 (0.1 part) |
| CL-2 | Liquid | | B-2 (60 parts) | Additive resin 4 (24 parts) C-2 (16 parts) Surfactant NBX-15 (0.1 part) |

Upper layer compositions were prepared as follows.

### <Preparation of upper layer composition U-1>

As shown in Table 2, 100 parts of the polymer C-1, 50 parts of the crosslinking agent D-1, 20 parts of the crosslinking agent D-2, 25 parts of the initiator E-1, 3 parts of the initiator E-3, 106 parts of the organic solvent F-1 and 0.1 part of surfactant NBX-15 were mixed and stirred to give a uniform solution. The solution was filtered through a membrane filter having a pore size of 10 µm (capsule cartridge filter CCP-3-C1B manufactured by ADVANTEC). Consequently, an upper layer composition U-1 was obtained.

### <Preparation of upper layer composition U-2>

An upper layer composition U-2 was prepared in the same manner as the composition U-1, except that the components and amounts thereof were changed as shown in Table 2.

### <Preparation of upper layer transfer film UF-2>

A transfer film was prepared from the upper layer composition U-2 as follows. The upper layer composition U-2 was spin coated over an 11 cm-square polyethyleneterephthalate (PET) film having a thickness of 50 µm so that the dry film thickness would be 80 µm. The coating was dried in a convection oven at 120°C for 10 minutes.

[Table 2]

**Table 2**

| Upper layer compositions | | | | | | |
|---|---|---|---|---|---|---|
| Upper layer composition | State | Component C | Component D | Component E | Component F | Surfactant |
| | | Polymer with phenolic hydroxyl group | Crosslinking agent | Initiator | Solvent | |
| U-1 | Liquid | C-1 (100 parts) | D-1 (50 parts) D-2 (20 parts) | E-1 (25 parts) E-3 (3 parts) | F-1 (106 parts) | NBX-15 (0.1 part) |
| U-2 | Liquid | C-2 (100 parts) | D-1 (51.7 parts) | E-1 (18.4 parts) E-2 (4 parts) | F-2 (94 parts | NBX-15 (0.1 part) |
| UF-2 | Dry film | C-2 (100 parts) | D-1 (51.7 parts) | E-1 (18.4 parts) E-2 (4 parts) | F-2 (94 parts) | NBX-15 (0.1 part) |

### <Preparation of transfer film having two-layer laminated film>

A transfer film was prepared from the lower layer composition L-1 and the upper layer composition U-2 as follows. The upper layer composition U-2 was spin coated over an 11 cm-square polyethyleneterephthalate (PET) film having a thickness of 50 µm so that the dry film thickness would be 80 µm. The coating was dried in a convection oven at 110°C for 10 minutes. Subsequently, the lower layer composition U-2 was spin coated over the dry upper layer so that the dry film thickness would be 5 µm. The coating was dried in a convection oven at 120°C for 10 minutes.

Peeling solution and evaluation boards used in the formation of bumps were as follows.

### <Preparation of peeling solution>

A peeling solution 1 was prepared by adding 300 g of an aqueous tetramethylammonium hydroxide solution (25% by weight) and 200 g of isopropanol to 4,500 g of dimethyl sulfoxide, followed by stirring.

### <Preparation of evaluation board A>

On a 4-inch silicon wafer, a chromium layer was sputtered in a thickness of 1,000 angstroms, and a copper layer was sputtered thereon in a thickness of 1,000 angstroms.
Consequently, an evaluation board A was prepared.

### <Preparation of evaluation board B>

The sputtered surface of the evaluation board A was coated with a solder resist (product of JSR Corporation, the photosensitive insulating resin composition described in Example 1 of Japanese Patent Application No. 2000-334348). The solder resist contained (i) a cresol novolak resin containing m-cresol and p-cresol in a molar ratio of 60/40 (weight-average molecular weight in terms of polystyrene: 8,700), (ii) hexamethoxymethylmelamine, (iii) crosslinked fine particles, (iv) styryl-bis (trichloromethyl) -s-triadine, and (v) ethyl lactate. The coating was dried in a convection oven at 90°C for 10 minutes to give a uniform film having a thickness of 3 µm.

Subsequently, the film was photoexposed through a pattern mask with a high-pressure mercury lamp (aligner (MA-150 manufactured by Suss Microtech Inc.)) in a manner such that the dose was in the range of 300 to 500 mJ/cm² at a wavelength of 350 nm. Thereafter, post exposure baking (hereinafter, PEB) was performed in a convection oven at 90°C for 15 minutes. The film was developed by being paddled in a 2.38-wt% aqueous tetramethylammonium hydroxide solution at 23°C over a period of 2 to 3 minutes (pressure: 3 kgf·cm²). The developed film was photoexposed in a dose of 1,000 mJ/cm² at 350 nm wavelength with use of a high-pressure mercury lamp, and was subsequently heated in a convection oven at 150°C for 2 hours and at 170°C for 2 hours. Consequently, the film was cured. An evaluation board B was thus prepared.

These boards had a first aperture pattern which was a combination of:

a pattern of apertures 95 µm in diameter at 150 µm pitches; and
a patterns of apertures 80 µm in diameter at 125 µm pitches.
Bump-forming two-layer laminated films were fabricated as follows.

### (Preparation of bump-forming two-layer laminated film by spin coating)

### <Evaluation board A>

The evaluation board was spin coated with the lower layer composition such that the dry film thickness would be 5 µm. The coating was dried on a hot plate at 120°C for 5 minutes. The lower layer thus formed was spin coated with the upper layer composition such that the thickness of the dry laminated film would be 85 µm. The coating was dried on a hot plate at 120°C for 5 minutes. Consequently, a two-layer laminated film was produced.

### <Evaluation board B>

The evaluation board was spin coated with the lower layer composition such that the dry film thickness would be 5 µm. The coating was dried on a hot plate at 110°C for 10 minutes. The lower layer thus formed was spin coated with the upper layer composition such that the thickness of the dry laminated film would be 85 µm. The coating was dried on a hot plate at 110 °C for 10 minutes. Consequently, a two-layer laminated film was produced.

### <Lamination of bump-forming lower layer>

The lower layer transfer film was brought into contact with a board to transfer the lower layer thereon. The support film was peeled. Consequently, the dry lower layer was laminated on the board.

The lamination conditions were as follows:

Roll temperature: 120°C
Roll pressure: 0.4 MPa
Transportation speed: 0.5 m/min.

### <Lamination of bump-forming upper layer>

The upper layer transfer film was brought into contact with the lower layer on the board to transfer the upper layer thereon. Consequently, the dry upper layer was laminated on the board.

The lamination conditions were as follows:

Roll temperature: 120°C
Roll pressure: 0.4 MPa
Transportation speed: 0.5 m/min.

### <Lamination of bump-forming two-layer laminated film>

The transfer film having the two-layer laminated film was brought into contact with a board to transfer the two-layer laminated film thereon. Consequently, the two-layer laminated film was laminated on the board.

The lamination conditions were as follows:

Roll temperature: 120°C
Roll pressure: 0.4 MPa
Transportation speed: 0.5 m/min.
Examples described below were carried out using the above components, peeling solution and evaluation boards.

### [Example 1]

### Formation of pattern and bumps

### <Application>

The lower layer composition L-1 was spin coated over the evaluation board A, resulting in a lower layer 5 µm in thickness. The upper layer composition U-1 was spin coated on the lower layer to form an upper layer. Consequently, a two-layer laminated film having a thickness of 85 µm was fabricated. The laminated film was dried, and peripheral protrusions produced by the spin coating were removed with acetone.

### <Photoexposure>

The laminated film was photoexposed through a patterned glass mask with a high-pressure mercury lamp (aligner (MA-150 manufactured by Suss Microtech Inc.)) in a manner such that the dose was 1,000 mJ/cm² at a wavelength of 420 nm. During the photoexposure, the patterned glass mask was placed 30 µm away from the upper layer.

### <Development>

The photoexposed board was subjected to paddle development in an aqueous solution containing 2.38% tetramethylammonium hydroxide (hereinafter, abbreviated to as TMAH developing solution). The developer application time was generally 90 seconds and adjusted by 15 seconds. After the development, the board was rinsed with ion-exchange water for 60 seconds.

The patterned board had a plurality of apertures 50 µm x 50 µm in size.

After the development, the pattern configuration was inspected with an optical microscope and a scanning electron microscope, and was evaluated based on the following criteria. The results are set forth in Table 4.

### Pattern configuration:

AA: A pattern having 50 µm x 50 µm apertures was developed with no residual film, no floating and no peeling.
CC: A pattern having 50 µm x 50 µm apertures had residual film, floating or peeling. The development did not allow a margin of development time.

### <Solder filing>

The lower layer composition L-1 was spin coated over the evaluation board B, resulting in a lower layer 5 µm in thickness. The upper layer composition U-1 was spin coated on the lower layer to form an upper layer. Consequently, a two-layer laminated film having a thickness of 85 µm was fabricated. The laminated film was dried, and peripheral protrusions produced by the spin coating were removed by dropping acetone thereto.

The two-layer laminated film was photoexposed and developed to produce a pattern as described hereinabove. The photoexposure used a patterned glass mask that had a pattern of apertures (second aperture pattern) having a diameter larger by 5 to 10 µm than the apertures of the first aperture pattern, at positions corresponding to the apertures of the first aperture pattern. The first aperture pattern and the second aperture pattern had the relation shown in Table 3.

[Table 3]

**Table 3**

| | First aperture pattern | Second aperture pattern |
|---|---|---|
| At 150 µm pitch At 150 µm pitch | Aperture diameter: 95 µm | Aperture diameter: 100 µm |
| At 125 µm pitch | Aperture diameter: 80 µm | Aperture diameter: 90 µm |

The pattered film was photoexposed through a patterned glass mask with a high-pressure mercury lamp (aligner (MA-150 manufactured by Suss Microtech Inc.)) in a manner such that the dose was 5, 000 mJ/cm² at a wavelength of 420 nm. The film was baked in a clean oven at 100°C for 30 minutes to accelerate curing of the upper layer.

The entire surface of the two-layer laminated film was coated with a solder paste with use of a squeegee, and the solder-bump-forming concave apertures were completely filled with the solder paste. The solder paste used herein was ECO SOLDER Paste M705-221BM5-10-11 manufactured by Senju Metal Industry Co., Ltd. (Sn:Ag:Cu=96.5:3:0.5 by weight) and contained solder particles 5 to 20 µm in diameter. The viscosity thereof had been adjusted to 190 Pa·s. Thereafter, the solder paste was removed using a squeegee from the surface other than within the solder-bump-forming apertures. The surface of the solder paste was flattened.

### <Reflowing>

The solder paste printed in the above step was reflowed at temperatures up to 250°C. The board was observed with an optical microscope to evaluate printing properties of the solder paste.

### Evaluation criteria

### Solder paste printing properties:

AA: Solder balls were uniformly spherical without the so-called bridges that were a result of joining together of solder balls. Solder balls were not formed in the resist apertures.
CC: Solder balls were nonuniform in shape and joined together to cause the so-called bridges. No solder balls were formed in the resist apertures.

### <Peeling>

1 liter of dimethyl sulfoxide was placed in a peeling bath and heated to 30°C. The board with the reflowed bumps was soaked in the peeling bath for 30 minutes with stirring, and thereby the two-layer laminated film was peeled. The board from which the laminated film had been peeled in the peeling bath was visually observed to evaluate the peeling.

### Evaluation criteria

### Peelability with DMSO:

AA: Most of the two-layer laminated film was peeled.
CC: The two-layer laminated film was not peeled.

Separately, 1 liter of the peeling solution 1 was placed in a peeling bath and heated to 30°C. The board treated with DMSO was soaked in the peeling bath for 20 minutes with stirring, and thereby the residual two-layer laminated film was peeled. The board was rinsed with isopropyl alcohol, washed with water and dried using an air gun.

After the peeling treatment, the board surface and the solder bumps were inspected with an optical microscope and a scanning electron microscope, and were evaluated based on the following criteria.

### Peelability with the peeling solution 1

AA: No residual film was observed on the board.
BB: Visual observation did not find a residual film on the board, but the optical microscope inspection confirmed a residual film.
CC: Residual film was observed on the board by visual inspection.

The results in Example 1 are shown in Table 4.

### [Examples 2 to 7]

The lower layer compositions and upper layer compositions in combination as given in Table 4 were evaluated in the same manner as in Example 1. The results are shown in Table 4.

### [Example 8]

The lower layer transfer film LF-1 was laminated on each of the evaluation boards A and B to provide a lower layer. The upper layer composition U-1 was spin coated thereon to form an upper layer. Consequently, laminated films having a thickness of 85 µm were fabricated. A pattern and bumps were produced and evaluated in the same manner as in Example 1 . The results are shown in Table 4.

### [Example 9]

The lower layer composition U-1 was spin coated on each of the evaluation boards A and B to form a lower layer. The upper layer transfer film UF-2 was laminated thereon to provide an upper layer. Consequently, laminated films having a thickness of 85 µm were fabricated. A pattern and bumps were produced and evaluated in the same manner as in Example 1 . The results are shown in Table 4.

### [Example 10]

The lower-layer transfer film LF-1 was laminated on each of the evaluation boards A and B to provide a lower layer. The upper layer transfer film UF-2 was laminated thereon to provide an upper layer. Consequently, laminated films having a thickness of 85 µm were fabricated. A pattern and bumps were produced and evaluated in the same manner as in Example 1. The results are shown in Table 4.

### [Example 11]

The transfer film having the bump-forming two-layer laminated film was laminated on each of the evaluation boards A and B. Consequently, two-layer laminated films having a thickness of about 85 µm were fabricated. A pattern and bumps were produced and evaluated in the same manner as in Example 1. The results are shown in Table 4.

### [Comparative Example 1]

The upper layer composition U-1 was spin coated on each of the evaluation boards A and B to provide an upper layer. Lower layers were not formed. A pattern and bumps were produced and evaluated in the same manner as in Example 1. The results are shown in Table 4.

### [Comparative Example 2]

A pattern and bumps were produced and evaluated in the same manner as in Comparative Example 1, except that the upper layer composition U-1 was replaced by the upper layer composition U-2 according to Table 4. The results are shown in Table 4.

### [Comparative Example 3 and 4]

A pattern and bumps were produced and evaluated in the same manner as in Example 1, except that the lower layer composition was replaced by CL-1 or CL-2 according to Table 4. The results are shown in Table 4.

[Table 4]

**Table 4**

| Examples | | | | | | |
|---|---|---|---|---|---|---|
| | Lower layer composition | Upper layer composition | Pattern configuration | Solder paste printing properties | Peelability (DMSO at 30°C) | Peelability (Peeling solution 1 at 30°C) |
| Ex. 1 | L-1 | U-1 | AA | AA | AA | AA |
| Ex. 2 | L-2 | U-1 | AA | AA | AA | AA |
| Ex. 3 | L-3 | U-1 | AA | AA | AA | AA |
| Ex. 4 | L-4 | U-1 | AA | AA | AA | AA |
| Ex. 5 | L-5 | U-1 | AA | AA | AA | AA |
| Ex . 6 | L-6 | U-1 | AA | Ap, | AA | AA |
| Ex. 7 | L-1 | U-2 | AA | AA | AA | AA |
| Ex. 8 | LF-1 | U-1 | AA | AA | Ap, | AA |
| Ex. 9 | L-1 | UF-2 | AA | AA | AA | AA |
| Ex. 10 | LF-1 | UF-2 | AA | AA | AA | AA |
| Ex. 11 | Two-layer dry film | | AA | AA | AA | AA |
| Comp. Ex. 1 | | U-1 | AA | AA | CC | CC |
| Comp. Ex. 2 | | U-2 | AA | AA | CC | CC |
| Comp. Ex. 3 | CL-1 | U-1 | AA | AA | CC | BB |
| Comp. Ex. 4 | CL-2 | U-1 | AA | AA | CC | AA |

## Claims

1. A two-layer laminated film for forming bumps, comprising:
(I) a lower layer comprising a composition including a polymer (A) and an organic solvent (B); and
(II) an upper layer comprising a negative radiation-sensitive resin composition;
the polymer (A) including a structural unit represented by Formula (1) : 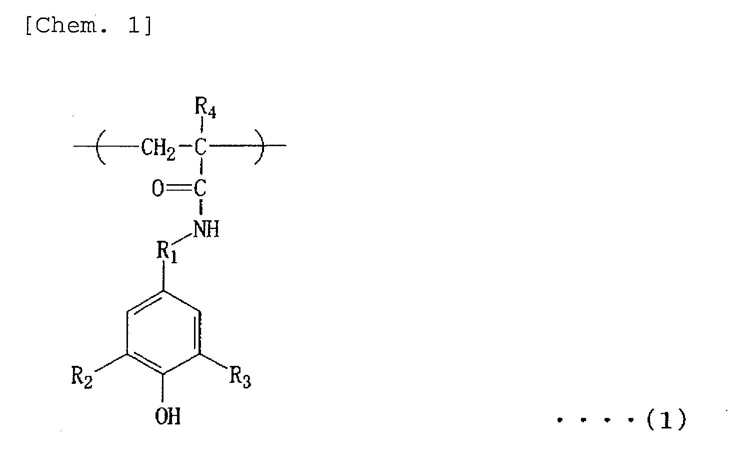
wherein R₁ is -(CH₂)ₙ- where n is an integer of 0 to 3, and R₂, R₃ and R₄ are the same or different from one another and are each a hydrogen atom or an alkyl group of 1 to 4 carbon atoms.

2. The two-layer laminated film for forming bumps according to claim 1, wherein the negative radiation-sensitive resin composition for the upper layer (II) includes a polymer having a carboxyl group and/or a phenolic hydroxyl group (C), a crosslinking agent (D), a radiation-activated radical polymerization initiator (E), and an organic solvent (F).

3. The two-layer laminated film for forming bumps according to claim 2, wherein the polymer (C) has a glass transition temperature (Tg) of not less than 40°C.

4. A transfer film comprising the laminated film claimed in claim 1 and a support film on which the laminated film is provided.

5. A process for forming bumps on electrode pads on a wiring board, comprising at least:
(a) a step of providing the two-layer laminated film claimed in claim 1 on a substrate and forming a pattern of apertures at positions corresponding to electrode pads;
(b) a step of introducing a low-melting metal in the apertures;
(c) a step of reflowing the low-melting metal by heating to form bumps; and
(d) a step of peeling and removing the two-layer laminated film from the substrate.

6. A process for forming bumps on electrode pads on a wiring board, comprising at least:
(a) a step of providing the two-layer laminated film claimed in claim 1 on a substrate and forming a pattern of apertures at positions corresponding to electrode pads;
(b) a step of introducing a low-melting metal in the apertures;
(d') a step of peeling and removing the two-layer laminated film from the substrate; and
(c') a step of reflowing the low-melting metal by heating to form bumps.
